# EUROPEAN PATENT APPLICATION

(11) **EP 2 876 681 A1**
(43) Date of publication of application: **27.05.2015**
(21) Application number: 14176072.8
(22) Date of filing: 08.07.2014
(51) Int. Cl.: H01L 25/075

(54) **Light emitting device**

(30) Priority: 22.11.2013 JP 2013242042
(71) Applicant: Toshiba Lighting & Technology Corporation, Yokosuka-shi Kanagawa 237-8510 (JP)
(72) Inventor: Betsuda, Nobuhiko, Kanagawa, 237-8510 (JP); Sasaki, Akihiro, Kanagawa, 237-8510 (JP); Okawa, Hideki, Kanagawa, 237-8510 (JP); Shimokawa, Kazuo, Kanagawa, 237-8510 (JP)
(74) Representative: Bokinge, Ole

(57) **Abstract**

According to an exemplary embodiment, there is provided a light emitting device (110) including a ceramic substrate (10), first to fourth connectors (48a, 48b, 48c, and 48d), a plurality of semiconductor light emitting elements (20), and a first metal layer (11). The ceramic substrate (10) is provided with a first main surface (10a) including first to fourth sides (10c, 10d, 10e, and 10f) and first to fourth corner portions (10g, 10h, 10i, and 10j). The first main surface (10a) further includes a mounting region (16), a first connector region (10k) provided between the mounting region (16) and the first corner portion (10g), a second connector region (10l) provided between the second corner portion (10h) and the mounting region (16), a third connector region (10m) provided between the third corner portion (10i) and the mounting region (16), and a fourth connector region (10n) provided between the fourth corner portion (10j) and the mounting region (16). The plurality of semiconductor light emitting elements (20) are provided on the mounting region (16). The first to fourth connectors (48a, 48b, 48c, and 48d) are respectively provided on the first to fourth connector regions (10k, 10l, 10m, and 10n). The first metal layer (11) is provided between the plurality of semiconductor light emitting elements (20) and the ceramic substrate (10), and includes first to fourth connector electrode portions (47a, 47b, 47c, and 47d) which are respectively electrically connected to the first to fourth connectors (48a, 48b, 48c, and 48d).

## Description

### FIELD

Exemplary embodiments described herein relate generally to a light emitting device.

### BACKGROUND

For example, there is a light emitting device (chip on board) in which a semiconductor light emitting element is mounted on a substrate and is sealed with a resin. Increasing an output level is desirable in such a light emitting device. However, if the output level is increased, reliability tends to deteriorate.

### BRIEF DESCRIPTION OF THE DRAWINGS

Figs. 1A to 1C are schematic views illustrating a light emitting device and a lighting device according to a first exemplary embodiment;
Fig. 2 is a schematic plan view illustrating a part of the light emitting device;
Fig. 3 is a schematic plan view illustrating an example of the light emitting device;
Fig. 4 is a schematic plan view illustrating a part of the light emitting device;
Figs. 5A and 5B are schematic views illustrating the light emitting device;
Fig. 6 is a graph illustrating characteristics of sintered alumina;
Fig. 7 is a graph illustrating characteristics of alumina;
Fig. 8 is a graph illustrating characteristics of sintered alumina;
Fig. 9 is a graph illustrating characteristics of sintered alumina;
Fig. 10 is a graph illustrating characteristics of alumina;
Fig. 11 is a graph illustrating characteristics of sintered alumina;
Fig. 12 is a graph illustrating characteristics of sintered alumina; and
Fig. 13 is a graph illustrating characteristics of sintered alumina.

### DETAILED DESCRIPTION

A light emitting device according to an exemplary embodiment includes a ceramic substrate, a first connector, a second connector, a third connector, a fourth connector, a plurality of light emitting elements, and a first metal layer. The ceramic substrate is provided with a first main surface including a first side; a second side apart from the first side; a third side; a fourth side apart from the third side; a first corner portion connecting the first side to the third side; a second corner portion connecting the third side to the second side; a third corner portion connecting the second side to the fourth side; a fourth corner portion connecting the fourth side to the first side; a mounting region; a first connector region provided between the mounting region and the first corner portion; a second connector region provided between the second corner portion and the mounting region; a third connector region provided between the third corner portion and the mounting region; and a fourth connector region provided between the fourth corner portion and the mounting region. The plurality of semiconductor light emitting elements are provided on the mounting region. The first connector is provided on the first connector region. The second connector is provided on the second connector region. The third connector is provided on the third connector region. The fourth connector is provided on the fourth connector region. The first metal layer is provided between the plurality of semiconductor light emitting elements and the ceramic substrate. The first metal layer includes a first connector electrode portion electrically connected to the first connector; a second connector electrode portion electrically connected to the second connector; a third connector electrode portion electrically connected to the third connector; and a fourth connector electrode portion electrically connected to the fourth connector.

Hereinafter, each exemplary embodiment will be described with reference to the drawings.

In addition, the drawings are schematic or conceptual, and a relationship between a thickness and a width of each part, a ratio of sizes between parts, and the like are not necessarily the same as practical ones. Further, even if the same parts are illustrated, dimensions or ratios of each other may be illustrated to be different depending on the drawings.

Furthermore, in the present specification and the respective drawings, the same constituent elements described above in the previous drawings are given the same reference numerals, and detailed description thereof will not be repeated as appropriate.

### First Exemplary Embodiment

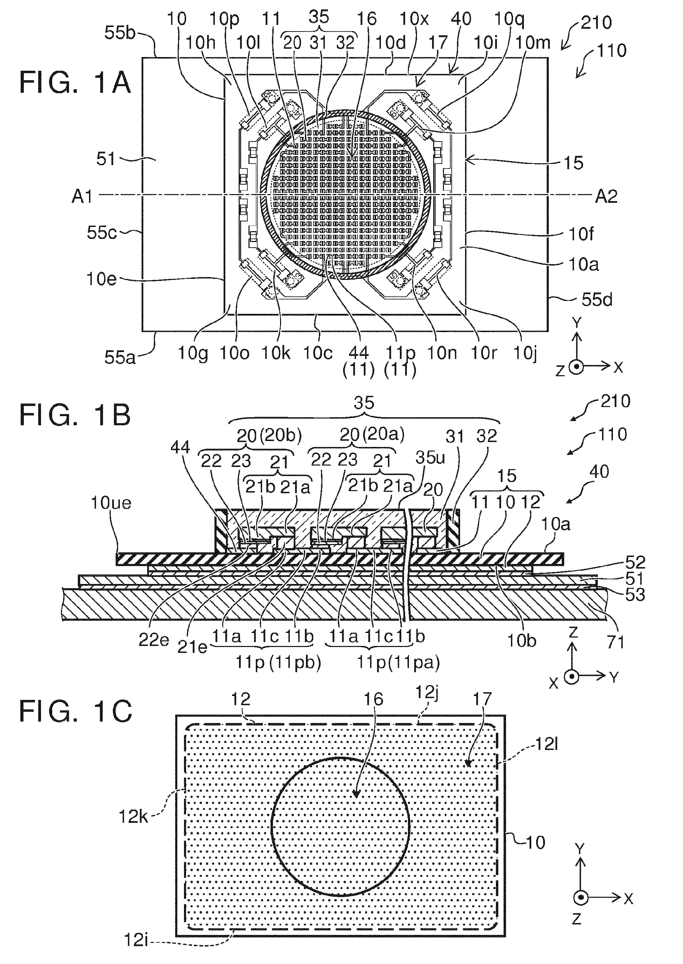

Figs. 1A to 1C are schematic views exemplifying a light emitting device and a lighting device according to a first exemplary embodiment.

Fig. 1A is a plan view. Fig. 1B is a cross-sectional view exemplifying a part of a cross-section taken along the line A1-A2 of Fig. 1A.

As illustrated in Figs. 1A and 1B, a light emitting device 110 according to the exemplary embodiment includes a base member 71, a grease layer 53, a heat dissipation plate 51, a joint layer 52, a mounting substrate portion 15, and a plurality of semiconductor light emitting elements 20. The light emitting device 110 is used in, for example, a lighting device 210.

A direction from the base member 71 to the mounting substrate portion 15 is assumed to be a laminate direction (Z axis direction). One direction perpendicular to the Z axis direction is set as an X axis direction. A direction perpendicular to the Z axis direction and the X axis direction is set as a Y axis direction.

The grease layer 53, the heat dissipation plate 51, the joint layer 52 (solder layer), the mounting substrate portion 15, and the plurality of semiconductor light emitting elements 20 are disposed on the base member 71 in this order.

In other words, the plurality of semiconductor light emitting elements 20 are apart from the base member 71 in the Z axis direction. The mounting substrate portion 15 includes a ceramic substrate 10. The ceramic substrate 10 has an upper surface 10ue. A member made of, for example, a ceramic or a composite ceramic of a ceramic and a resin is used in the ceramic substrate 10. As the ceramic, for example, aluminum oxide (Al₂O₃), aluminum nitride (AIN), beryllium oxide (BeO), steatite (MgO·SiO₂), zircon (ZrSiO₄), silicon nitride (Si₃N₄), or the like is used. The ceramic substrate 10 is provided between the base member 71 and the plurality of semiconductor light emitting elements 20. The heat dissipation plate 51 is provided between the base member 71 and the mounting substrate portion 15.

As exemplified in Fig. 1B, the joint layer 52 is provided between the mounting substrate portion 15 and the heat dissipation plate 51. The joint layer 52 joins the mounting substrate portion 15 to the heat dissipation plate 51.

The grease layer 53 is provided between the base member 71 and the heat dissipation plate 51. The grease layer 53 transmits heat of the heat dissipation plate 51 to the base member 71.

Hereinafter, a description will be made of an example of the light emitting device 110 (and the lighting device 210) illustrated Figs. 1A to 1C.

A light emitting section 40 is provided in the light emitting device 110. The light emitting section 40 is provided on the heat dissipation plate 51. The joint layer 52 is provided between the heat dissipation plate 51 and the light emitting section 40.

In the present specification, a state in which a certain constituent element is provided on another constituent element includes not only a state in which the constituent element is directly provided on another electrode, but also a state in which other constituent elements are interposed therebetween.

A direction from the heat dissipation plate 51 to the light emitting section 40 corresponds to the laminate direction. In the present specification, a laminate state includes not only a state in which a certain constituent element directly overlaps another constituent element, but also a state in which the constituent element overlaps another constituent element with other constituent elements interposed therebetween.

The heat dissipation plate 51 has, for example, a plate shape. A main surface of the heat dissipation plate 51 is substantially parallel to, for example, an X-Y plane. A planar shape of the heat dissipation plate 51 is, for example, a rectangular shape. The heat dissipation plate 51 includes, for example, first to fourth heat dissipation plate sides 55a to 55d. The second heat dissipation plate side 55b is apart from the first heat dissipation plate side 55a. The third heat dissipation plate side 55c connects one end of the first heat dissipation plate side 55a to one end of the second heat dissipation plate side 55b. The fourth heat dissipation plate side 55d is apart from the third heat dissipation plate side 55c, and connects the other end of the first heat dissipation plate side 55a to the other end of the second heat dissipation plate side 55b. A planar corner portion of the heat dissipation plate 51 may be curved.

The light emitting section 40 emits light. The light emitting section 40 also generates heat. The joint layer 52 conducts the heat generated by the light emitting section 40 to the heat dissipation plate 51 with high efficiency. For example, solder or the like is used in the joint layer 52. In other words, the joint layer 52 includes the solder. For example, solder which has tin as a base and includes any one of gold, silver, copper, bismuth, nickel, indium, zinc, antimony, germanium, and silicon as at least one kind, is used in the joint layer 52. For example, a SnAgCu alloy or the like is used.

The light emitting section 40 includes the mounting substrate portion 15 and a light emitting element portion 35.

The mounting substrate portion 15 includes the ceramic substrate 10, a first metal layer 11, and a second metal layer 12.

The ceramic substrate 10 has a first main surface 10a and a second main surface 10b. The second main surface 10b is an opposite surface to the first main surface 10a. The heat dissipation plate 51 faces the second main surface 10b of the ceramic substrate 10. In other words, the second main surface 10b is a surface on the heat dissipation plate 51 side. That is, the second main surface 10b is a surface on the joint layer 52 side.

The light emitting element portion 35 is provided on the first main surface 10a of the ceramic substrate 10. The light emitting element portion 35 includes the plurality of semiconductor light emitting elements 20 and a wavelength conversion layer 31.

In the present specification, a facing state includes not only a state in which a certain constituent element directly faces another constituent element, but also a state in which the constituent element faces another constituent element with other constituent elements interposed therebetween.

The first main surface 10a includes a mounting region 16. For example, the mounting region 16 is apart from an outer edge 10x of the first main surface 10a. In this example, the mounting region 16 is provided at a central part of the first main surface 10a. The first main surface 10a further includes a peripheral region 17. The peripheral region 17 is provided around the mounting region 16.

The first main surface 10a is substantially parallel to, for example, the X-Y plane. A planar shape of the ceramic substrate 10 is, for example, a rectangular shape. The first main surface 10a has, for example, first to fourth sides 10c to 10f. The second side 10d is apart from the first side 10c. The third side 10e connects one end of the first side 10c to one end of the second side 10d. The third side 10e is provided between the first side 10c and the second side 10d. The fourth side 10f is apart from the third side 10e, and connects the other end of the first side 10c to the other end of the second side 10d. The fourth side 10f is provided between the first side 10c and the second side 10d.

The first main surface 10a includes first to fourth corner portions 10g to 10j. The first corner portion 10g connects the first side 10c to the third side 10e. The second corner portion 10h connects the second side 10d to the third side 10e. The third corner portion 10i connects the second side 10d to the fourth side 10f. The fourth corner portion 10j connects the fourth side 10f to the first side 10c.

The first main surface 10a includes first to fourth connector regions 10k to 10n. The first connector region 10k is provided between the mounting region 16 and the first corner portion 10g. The second connector region 10l is provided between the mounting region 16 and the second corner portion 10h. The third connector region 10m is provided between the mounting region 16 and the third corner portion 10i. The fourth connector region 10n is provided between the mounting region 16 and the fourth corner portion 10j.

The first main surface 10a further includes fifth to eighth connector regions 10o to 10r. The fifth connector region 10o is provided between the first corner portion 10g and the first connector region 10k. The sixth connector region 10p is provided between the second corner portion 10h and the second connector region 10l. The seventh connector region 10q is provided between the third corner portion 10i and the third connector region 10m. The eighth connector region 10r is provided between the fourth corner portion 10j and the fourth connector region 10n.

The ceramic substrate 10 includes, for example, at least one of alumina and aluminum nitride. For example, a ceramic which has alumina as a main component is used in the ceramic substrate 10. High thermal conductivity and high insulation can be obtained. High reliability can be obtained.

The first metal layer 11 is provided on the first main surface 10a. For example, the first metal layer 11 is provided between the ceramic substrate 10 and the plurality of semiconductor light emitting elements 20. The first metal layer 11 may include first to fourth mounting pattern portions 11fa to 11fd described later. For example, each of the first to fourth mounting pattern portions 11fa to 11fd includes a plurality of mounting patterns 11p. Two or more of the plurality of mounting patterns 11p are apart from each other. For example, at least one of the plurality of mounting patterns 11p has an island shape. Two of the plurality of mounting patterns 11p is independent from each other. The plurality of mounting patterns 11p include, for example, a first mounting pattern 11pa, a second mounting pattern 11pb, and the like.

Each of the plurality of mounting patterns 11p includes, for example, a first mounting part 11a and a second mounting part 11b. In this example, the mounting patterns 11p further include a third mounting part 11c. The third mounting part 11c is provided between the first mounting part 11a and the second mounting part 11b, so as to connect the first mounting part 11a to the second mounting part 11b. An example of the mounting parts will be described later.

The first metal layer 11 may further include a connection portion 44 which connects the plurality of mounting patterns 11p to each other. For example, the first metal layer 11 electrically connects first to eighth connectors 48a to 48h to each other. Power is supplied to the light emitting element portion 35 via the first metal layer 11.

The second metal layer 12 is provided on the second main surface 10b. The second metal layer 12 is electrically connected to the first metal layer 11. At least a part of the second metal layer 12 overlaps the mounting region 16 when projected on the X-Y plane (a first plane parallel to the first main surface 10a). For example, the joint layer 52 is provided between the second metal layer 12 and the heat dissipation plate 51.

Fig. 1C is a projection plan view exemplifying a part of the light emitting device 110.

The second metal layer 12 is apart from the outer edge 10x. A planar shape of the second metal layer 12 is, for example, a rectangular shape. Te second metal layer 12 has first to fourth metal sides 12i to 121. The second metal side 12j is apart from the first metal side 12i. The third metal side 12k connects one end of the first metal side 12i to one end of the second metal side 12j. The fourth metal side 121 is apart from the third metal side 12k, and connects the other end of the first metal side 12i to the other end of the second metal side 12j. Intersections between the respective sides, that is, corner portions may be curved (R shape). A planar shape of the second metal layer 12 may not be a rectangular shape, and may be any shape.

In this example, the plurality of semiconductor light emitting elements 20 are arranged in an array form. The semiconductor light emitting elements 20 are arranged, for example, in a substantially circular shape. For example, the semiconductor light emitting elements 20 are arranged at substantially equal pitches. Accordingly, for example, light sources are gathered in one, and thus the light sources can be made small-sized. Each of the plurality of semiconductor light emitting elements 20 emits light. The semiconductor light emitting element 20 includes, for example, a nitride semiconductor. The semiconductor light emitting element 20 includes, for example, In_{y}Al_{z}Ga_{1-x-y}N (where 0≤x≤1, 0≤y≤1, and x+y≤1). However, in the exemplary embodiment, any semiconductor light emitting element 20 may be used.

The plurality of semiconductor light emitting elements 20 include, for example, a first semiconductor light emitting element 20a, a second semiconductor light emitting element 20b, and the like.

The plurality of semiconductor light emitting elements 20 are provided on the first metal layer 11. Each of the plurality of semiconductor light emitting elements 20 is electrically connected to one plurality of mounting patterns 11p among the plurality of mounting patterns 11p, and another mounting pattern 11p around the one mounting pattern 11p among the plurality of mounting patterns 11p.

For example, the first semiconductor light emitting element 20a is electrically connected to the first mounting pattern 11pa and the second mounting pattern 11pb among the plurality of mounting patterns 11p. The second mounting pattern 11pb corresponds to another mounting pattern 11p around the first mounting pattern 11pa.

For example, each of the plurality of semiconductor light emitting elements 20 includes a first conductivity type first semiconductor layer 21, a second conductivity type second semiconductor layer 22, and a light emitting layer 23. For example, the first conductivity type is an n type, and the second conductivity type is a p type. The first conductivity type may be a p type, and the second conductivity type may be an n type.

The first semiconductor layer 21 includes a first part (a first semiconductor part 21a) and a second part (a second semiconductor part 21b). The second semiconductor part 21b is arranged with the first semiconductor part 21a in a direction (for example, the X axis direction) intersecting the laminate direction (the Z axis direction from the heat dissipation plate 51 to the light emitting section 40).

The second semiconductor layer 22 is provided between the second semiconductor part 21b and the mounting substrate portion 15. The light emitting layer 23 is provided between the second semiconductor part 21b and the second semiconductor layer 22.

The semiconductor light emitting element 20 is, for example, a flip chip type LED.

For example, the first semiconductor part 21a of the first semiconductor layer 21 faces the first mounting part 11a of the mounting pattern 11p. The second semiconductor layer 22 faces the second mounting part 11b of the mounting pattern 11p. The first semiconductor part 21a of the first semiconductor layer 21 is electrically connected to the mounting pattern 11p. The second semiconductor layer 22 is electrically connected to another mounting pattern 11p. Solder or a gold bump having high electric conductivity and thermal conductivity is used for the connection. The connection is performed by, for example, molten metal soldering joint. Alternatively, the connection is performed in, for example, an ultrasonic heat-compression method using a gold bump.

In other words, for example, the light emitting element portion 35 further includes a first joint metal member 21e and a second joint metal member 22e. The first joint metal member 21e is provided between the first semiconductor part 21a and any one (for example, the first mounting part 11a) of the mounting patterns 11p. The second joint metal member 22e is provided between the second semiconductor layer 22 and another mounting pattern 11p (for example, the second mounting pattern 11pb). At least one of the first joint metal member 21e and the second joint metal member 22e includes solder or a gold bump. Accordingly, a cross-section area (a cross-section area when cut in the X-Y plane) of each of the first joint metal member 21e and the second joint metal member 22e can be increased. Thus, heat can be transmitted to the mounting substrate portion 15 via the first joint metal member 21e and the second joint metal member 22e with high efficiency, and thus a heat dissipation property improves.

For example, another metal layer may be provided between the semiconductor light emitting element 20 and the mounting substrate portion 15. Accordingly, oxidation of the first metal layer can be prevented, or wettability with the solder can be increased. This metal layer is not electrically connected to the semiconductor light emitting element 20 and the mounting pattern 11p. This metal layer has no relation to a circuit.

The wavelength conversion layer 31 covers at least some of the plurality of semiconductor light emitting elements 20. The wavelength conversion layer 31 at least some light (for example, first light) emitted from the plurality of semiconductor light emitting elements 20 so as to emit second light. A wavelength (for example, a peak wavelength) of the second light is different from a wavelength (for example, a peak wavelength) of the first light. The wavelength conversion layer 31 includes, for example, a plurality of wavelength conversion particles such as phosphors and a light transmissive resin in which the plurality of wavelength conversion particles are dispersed. The first light includes, for example, blue light. The second light includes light whose wavelength is longer than a wavelength of the first light. The second light includes, for example, at least one of yellow light and red light.

In this example, the light emitting element portion 35 further includes a reflective layer 32. The reflective layer 32 surrounds the wavelength conversion layer 31 in the X-Y plane. The reflective layer 32 includes, for example, a plurality of particles of metal oxide or the like, and a light transmissive resin in which the particles are dispersed. The particles of the metal oxide or the like have a light reflection property. As the particles of the metal oxide or the like, for example, at least one of TiO₂ and Al₂O₃ may be used. The reflective layer 32 is provided, and thus light emitted from the semiconductor light emitting element 20 can be emitted in a direction (for example, an upward direction) along the laminate direction with high efficiency.

The light emitting section 40 is, for example, a chip on board (COB) type LED module.

In the present exemplary embodiment, luminous radiance of light emitted from the light emitting element portion 35 (the plurality of semiconductor light emitting elements 20) is 10 lm/mm² (lumen/square millimeters) or more and 100 lm/mm² or less. The luminous radiance is preferably 20 lm/mm² or more. In other words, in the present exemplary embodiment, a ratio (luminous radiance) of light emitted from the light emitting element portion 35 to an emission area is very high. In the present specification, the emission area substantially corresponds to an area of the mounting region 16.

The light emitting device 110 according to the present exemplary embodiment is used in, for example, the lighting device 210 such as a projector.

A liquid or liquid lubricant (grease) is used in the grease layer 53. For example, an insulating lubricant (insulating grease) or a conductive lubricant (conductive grease) may be used in the grease layer 53. The insulating grease contains, for example, silicon and ceramic particles dispersed in the silicon. The conductive grease contains, for example, silicon and metal particles dispersed in the silicon. Higher thermal conductivity can be obtained in the conductive grease, for example, than the insulating grease. For example, heat from the light emitting element portion 35 is conducted to the base member 71 by the grease layer 53 so as to be dissipated.

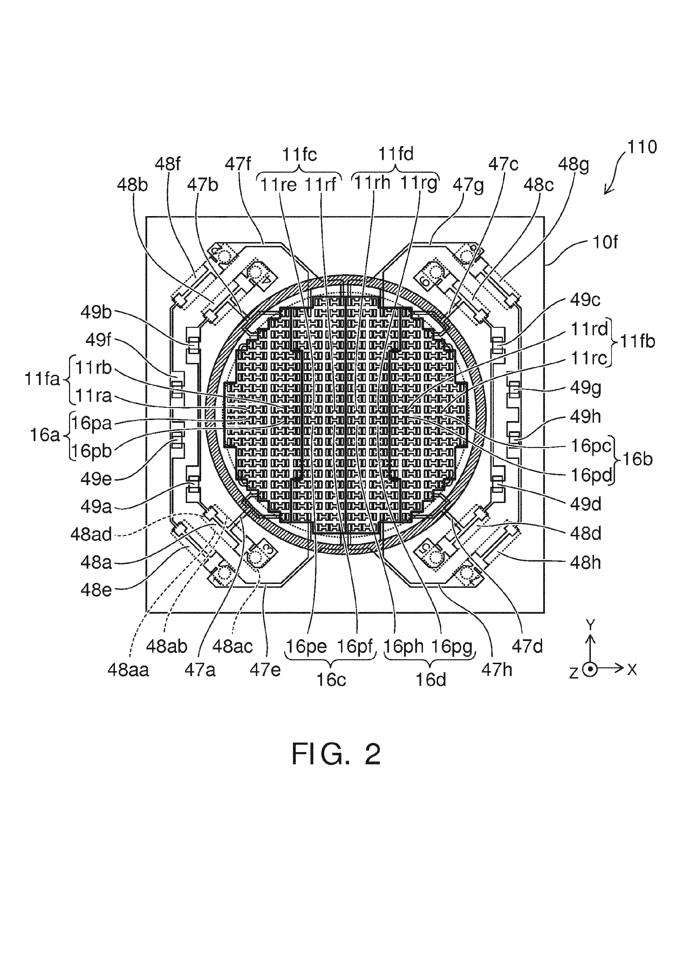

Fig. 2 is a schematic plan view exemplifying a part of the light emitting device according to the first exemplary embodiment.

As illustrated in Fig. 2, the mounting region 16 includes first to fourth arrangement portions 16a to 16d. The second arrangement portion 16b is provided between the fourth side 10f and the first arrangement portion 16a. The third arrangement portion 16c is provided between the first arrangement portion 16a and the second arrangement portion 16b. The fourth arrangement portion 16d is provided between the second arrangement portion 16b and the third arrangement portion 16c.

For example, the first arrangement portion 16a may include a first part 16pa and a second part 16pb. The second arrangement portion 16b may include a third part 16pc and a fourth part 16pd. The third arrangement portion 16c may include a fifth part 16pe and a sixth part 16pf. The fourth arrangement portion 16d may include a seventh part 16pg and an eighth part 16ph.

The second part 16pb is provided between the first part 16pa and the third part 16pc. The fourth part 16pd is provided between the second part 16pb and the third part 16pc. The sixth part 16pf is provided between the fourth part 16pd and the fifth part 16pe. The eighth part 16ph is provided between the sixth part 16pf and the seventh part 16pg.

The first to fourth mounting pattern portions 11fa to 11fd are respectively provided on the first to fourth arrangement portions 16a to 16d.

The first mounting pattern portion 11fa is provided on the first arrangement portion 16a. The second mounting pattern portion 11fb is provided on the second arrangement portion 16b. The third mounting pattern portion 11fc is provided on the third arrangement portion 16c. The fourth mounting pattern portion 11fd is provided on the fourth arrangement portion 16d.

The first mounting pattern portion 11fa may include a first mounting pattern region 11ra and a second mounting pattern region 11rb. The second mounting pattern portion 11fb may include a third mounting pattern region 11rc and a fourth mounting pattern region 11rd. The third mounting pattern portion 11fc may include a fifth mounting pattern region 11re and a sixth mounting pattern region 11rf. The fourth mounting pattern portion 11fd may include a seventh mounting pattern region 11rg and an eighth mounting pattern region 11rh. In this case, each of the first to eighth mounting pattern regions 11ra to 11rh includes the plurality of mounting patterns 11p.

The first metal layer 11 includes first to eighth connector electrode portions 47a to 47h.

The first connector electrode portion 47a is electrically connected to the first mounting pattern portion 11fa. The first connector electrode portion 47a is electrically connected to the first mounting pattern region 11ra and the second mounting pattern region 11rb.

The second connector electrode portion 47b is electrically connected to the first mounting pattern portion 11fa. The second connector electrode portion 47b is electrically connected to the first mounting pattern region 11ra and the second mounting pattern region 11rb.

The third connector electrode portion 47c is electrically connected to the second mounting pattern portion 11fb. The third connector electrode portion 47c is electrically connected to the third mounting pattern region 11rc and the fourth mounting pattern region 11rd.

The fourth connector electrode portion 47d is electrically connected to the second mounting pattern portion 11fb. The fourth connector electrode portion 47d is electrically connected to the third mounting pattern region 11rc and the fourth mounting pattern region 11rd.

The fifth connector electrode portion 47e is electrically connected to the third mounting pattern portion 11fc. The fifth connector electrode portion 47e is electrically connected to the fifth mounting pattern region 11re and the sixth mounting pattern region 11rf.

The sixth connector electrode portion 47f is electrically connected to the third mounting pattern portion 11fc. The sixth connector electrode portion 47f is electrically connected to the fifth mounting pattern region 11re and the sixth mounting pattern region 11rf.

The seventh connector electrode portion 47g is electrically connected to the fourth mounting pattern portion 11fd. The seventh connector electrode portion 47g is electrically connected to the seventh mounting pattern region 11rg and the eighth mounting pattern region 11rh.

The eighth connector electrode portion 47h is electrically connected to the fourth mounting pattern portion 11fd. The eighth connector electrode portion 47h is electrically connected to the seventh mounting pattern region 11rg and the eighth mounting pattern region 11rh.

For example, the semiconductor light emitting element 20 is disposed on a part of each of the plurality of mounting patterns 11p. Each of the first to eighth connector electrode portions 47a to 47h is electrically connected to any one of the plurality of mounting patterns 11p via the semiconductor light emitting element 20.

For example, a thickness of the first metal layer 11 is 100 micrometers (µm) or less. Accordingly, for example, a fine pattern can be formed.

For example, the light emitting section 40 includes the first to eighth connectors 48a to 48h. The first to eighth connectors 48a to 48h are respectively provided on first to eighth connector regions 10k to 10r.

The first connector 48a is provided on the first connector region 10k. The second connector 48b is provided on the second connector region 10l. The third connector 48c is provided on the third connector region 10m. The fourth connector 48d is provided on the fourth connector region 10n. The fifth connector 48e is provided on the fifth connector region 10o. The sixth connector 48f is provided on the sixth connector region 10p. The seventh connector 48g is provided on the seventh connector region 10q. The eighth connector 48h is provided on the eighth connector region 10r.

For example, the first to eighth connectors 48a to 48h are respectively electrically connected to the first to eighth connector electrode portions 47a to 47h.

The first connector 48a is electrically connected to the first connector electrode portion 47a. The second connector 48b is electrically connected to the second connector electrode portion 47b. The third connector 48c is electrically connected to the third connector electrode portion 47c. The fourth connector 48d is electrically connected to the fourth connector electrode portion 47d. The fifth connector 48e is electrically connected to the fifth connector electrode portion 47e. The sixth connector 48f is electrically connected to the sixth connector electrode portion 47f. The seventh connector 48g is electrically connected to the seventh connector electrode portion 47g. The eighth connector 48h is electrically connected to the eighth connector electrode portion 47h.

Power is supplied to the light emitting section 40 via the connectors. For example, a distance between each of the first to eighth connectors 48a to 48h and the light emitting element portion 35 is 2.5 millimeters (mm) or more. A distance between each of the first to eighth connector regions 10k to 10r and the mounting region 16 is 2.5 mm or more.

Power is supplied to the plurality of semiconductor light emitting elements 20 disposed on the mounting pattern 11p of the first mounting pattern portion 11fa via the first connector 48a and the second connector 48b.

For example, the plurality of semiconductor light emitting elements 20 disposed on the mounting pattern 11p of the first mounting pattern region 11ra is connected in series to each other. For example, the plurality of semiconductor light emitting elements 20 disposed on the mounting pattern 11p of the second mounting pattern region 11rb is connected in series to each other. For example, the plurality of semiconductor light emitting elements 20 disposed on the mounting pattern 11p of the first mounting pattern region 11ra and the plurality of semiconductor light emitting elements 20 disposed on the mounting pattern 11p of the second mounting pattern region 11rb are connected in parallel to each other.

Power is supplied to the plurality of semiconductor light emitting elements 20 disposed on the mounting pattern 11p of the second mounting pattern portion 11fb via the third connector 48c and the fourth connector 48d.

For example, the plurality of semiconductor light emitting elements 20 disposed on the mounting pattern 11p of the third mounting pattern region 11rc is connected in series to each other. For example, the plurality of semiconductor light emitting elements 20 disposed on the mounting pattern 11p of the fourth mounting pattern region 11rd is connected in series to each other. For example, the plurality of semiconductor light emitting elements 20 disposed on the mounting pattern 11p of the third mounting pattern region 11rc and the plurality of semiconductor light emitting elements 20 disposed on the mounting pattern 11p of the fourth mounting pattern region 11rd are connected in parallel to each other.

Power is supplied to the plurality of semiconductor light emitting elements 20 disposed on the mounting pattern 11p of the third mounting pattern portion 11fc via the fifth connector 48e and the sixth connector 48f.

For example, the plurality of semiconductor light emitting elements 20 disposed on the mounting pattern 11p of the fifth mounting pattern region 11re is connected in series to each other. For example, the plurality of semiconductor light emitting elements 20 disposed on the mounting pattern 11p of the sixth mounting pattern region 11rf is connected in series to each other. For example, the plurality of semiconductor light emitting elements 20 disposed on the mounting pattern 11p of the fifth mounting pattern region 11re and the plurality of semiconductor light emitting elements 20 disposed on the mounting pattern 11p of the sixth mounting pattern region 11rf are connected in parallel to each other.

Power is supplied to the plurality of semiconductor light emitting elements 20 disposed on the mounting pattern 11p of the fourth mounting pattern portion 11fd via the seventh connector 48g and the eighth connector 48h.

For example, the plurality of semiconductor light emitting elements 20 disposed on the mounting pattern 11p of the seventh mounting pattern region 11rg is connected in series to each other. For example, the plurality of semiconductor light emitting elements 20 disposed on the mounting pattern 11p of the eighth mounting pattern region 11rh is connected in series to each other. For example, the plurality of semiconductor light emitting elements 20 disposed on the mounting pattern 11p of the seventh mounting pattern region 11rg and the plurality of semiconductor light emitting elements 20 disposed on the mounting pattern 11p of the eighth mounting pattern region 11rh are connected in parallel to each other.

For example, the light emitting device 110 includes first to eighth capacitors 49a to 49h.

For example, the first capacitor 49a is disposed between the first connector 48a and the second connector 48b in the Y axis direction. The second capacitor 49b is disposed between the first capacitor 49a and the second capacitor 48b in the Y axis direction.

For example, the third capacitor 49c is disposed between the third connector 48c and the fourth connector 48d in the Y axis direction. The fourth capacitor 49d is disposed between the third capacitor 49c and the fourth connector 48d in the Y axis direction.

For example, the fifth capacitor 49e is disposed between the fifth connector 48e and the sixth connector 48f in the Y axis direction. The sixth capacitor 49f is disposed between the fifth capacitor 49e and the sixth connector 48f in the Y axis direction.

For example, the seventh capacitor 49g is disposed between the seventh connector 48g and the eighth connector 48h in the Y axis direction. The eighth capacitor 49h is disposed between the seventh capacitor 49g and the eighth connector 48h in the Y axis direction.

For example, a position of the fifth capacitor 49e in the Y axis direction and a position of the sixth capacitor 49f in the Y axis direction are located between a position of the first capacitor 49a in the Y axis direction and a position of the second capacitor 49b in the Y axis direction.

For example, a position of the seventh capacitor 49g in the Y axis direction and a position of the eighth capacitor 49h in the Y axis direction are located between a position of the third capacitor 49c in the Y axis direction and a position of the fourth capacitor 49d in the Y axis direction. Accordingly, for example, a distance between each of the first to eighth capacitors 49a to 49h and the light emitting element portion 35 can be lengthened. An increase in a temperature of each of the first to eighth capacitors 49a to 49h can be prevented, and thus reliability can be increased.

For example, a planar shape of each of the first to eighth connectors 48a to 48h is a rectangular shape. For example, the first connector 48a has first to fourth connector sides 48aa to 48ad. The first connector side 48aa is provided between the first corner portion 10g and the mounting region 16. The second connector side 48ab is provided between the first connector side 48aa and the mounting region 16. The first connector side 48aa is apart from the second connector side 48ab. The third connector side 48ac connects (is connected to) one end of the first connector side 48aa and one end of the second connector side 48ab to each other. The fourth connector side 48ad connects the other end of the first connector side 48aa to the other end of the second connector side 48ab. For example, the first connector side 48aa and the second connector side 48ab are substantially parallel to each other.

For example, the first connector side 48aa is longer than the third connector side 48ac, and is longer than the fourth connector side 48ad. For example, the second connector side 48ab is longer than the third connector side 48ac, and is longer than the fourth connector side 48ad.

The first connector side 48aa intersects a direction from the mounting region 16 to the first corner portion 10g. For example, an angle formed between an extending direction of the first connector side 48aa and a direction from the mounting region 16, particularly, a center of the mounting region 16 to the first corner portion 10g is 80 degrees or more and 100 degrees or less. For example, the first connector side 48aa is substantially perpendicular to the direction from the mounting region 16 to the first corner portion 10g (or from the mounting region 16 to the first connector 48a).

For example, when the first connector region 10k and the fifth connector region 10o are projected onto a plane perpendicular to the direction from the mounting region 16 (the center of the mounting region 16) to the first corner portion 10g, at least a part of the first connector region 10k does not overlap the fifth connector region 10o. For example, in this case, the first connector region 10k includes a part which overlaps the fifth connector region 10o and a part which does not overlap the fifth connector region 10o, and the fifth connector region 10o includes a part which overlaps the first connector region 10k and a part which does not overlap the first connector region 10k.

In other words, for example, a position of the first connector 48a and a position of the fifth capacitor 49e are disposed so as to deviate relative to a line which connects a center (for example, the center of the mounting region 16) of the first main surface 10a to a corner (for example, the first corner portion 10g) of the first main surface. As mentioned above, the two parallel connectors are disposed so as to deviate relative to the line which connects the center of the first main surface 10a to the corner of the first main surface, and thus a degree of freedom of forming a mounting pattern can be increased on the ceramic substrate 10 which has a limited space.

In the light emitting device 110 according to the present exemplary embodiment, for example, the first to eighth connectors 48a to 48h are respectively provided at any one of the first to fourth corner portions 10g to 10j.

For example, there is a COB module of a reference example in which two connectors are provided, and each connector is provided at portions other than a corner portion. For example, in the COB module of the reference example, a first connector is provided between a first corner portion and a second corner portion, and a second connector is provided between a third corner portion and a fourth corner portion. For example, in the COB module of the reference example, the semiconductor light emitting element 20 provided in the mounting region 16 is supplied with power via the first connector and the second connector. For example, the COB module of the reference example has input and output terminals of a single system at two corners at the most due to the connector arrangement.

If the COB module of the reference example is used, an output of the COB module used in a projector or the like is a high output of 200 W or more, and thus heat generated from a light source and a temperature difference of an exterior end of the product are considerably large. Rated currents of input and output connectors and a wiring substrate are increased. From the above description, reliability of a heat cycle and a blinking cycle may deteriorate.

In the light emitting device 110 according to the present exemplary embodiment, input and output connectors are disposed at the four corners (the first to fourth corner portions 10g to 10j) which allow the distances between an LED chip which is a heat generation source and a circular phosphor sealing resin (the light emitting element portion 35), and the input and output connectors (the first to eighth connectors 48a to 48h) to be lengthened (for example, the longest), and thus a connector temperature can be reduced.

For example, a temperature of the light emitting section 40 decreases in the direction from the mounting region to the corner portion. For example, a temperature of the light emitting section 40 decreases according to becoming distant from the light emitting element portion 35. In each of the input and output connectors, any one of a plurality of sides (for example, four sides) of the input and output connector is disposed so as to be substantially parallel to a direction from the mounting region to the input and output connector. Accordingly, a distance between the light emitting element portion 35 and the input and output connector can be lengthened. An increase in a connector temperature can be minimized.

Two input and output connectors are disposed at each corner portion, and thus rated currents of the input and output connector and the wiring substrate can be reduced. For example, a distance between the light emitting element portion 35 and the input and output connector is 2.5 mm or more. Accordingly, a connector temperature can be considerably reduced. The rated current can be considerably reduced. Reliability of a heat cycle and a blinking cycle is improved. According to the present exemplary embodiment, a light emitting device with high reliability is provided.

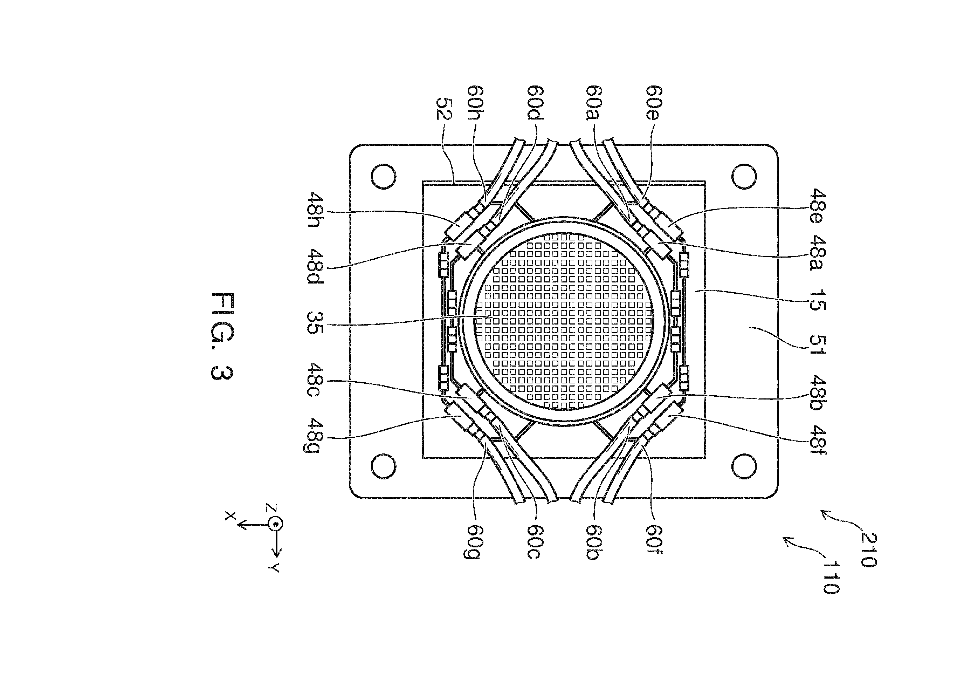

Fig. 3 is a schematic plan view exemplifying the light emitting device according to the first exemplary embodiment.

Fig. 3 illustrates the light emitting device 110 mounted with a chip and connector cables.

First to eighth connector cables 60a to 60h are respectively electrically connected to the first to eighth connectors 48a to 48h. Power is supplied to the light emitting element portion 35 via the first to eighth connector cables 60a to 60h. The connectors are disposed as in the first to eighth connectors 48a to 48h in the light emitting device 110 according to the exemplary embodiment, and thus the light emitting device 110 can be easily attached to a lighting apparatus. In addition, for example, since a polarity of each of the first connector 48a, the fourth connector 48d, the fifth connector 48e, and the eighth connector 48h is positive, and a polarity of each of the second connector 48b, the third connector 48c, the sixth connector 48f, and the seventh connector 48g is negative, electrical connection can be easily performed without difficulty in handling the cables.

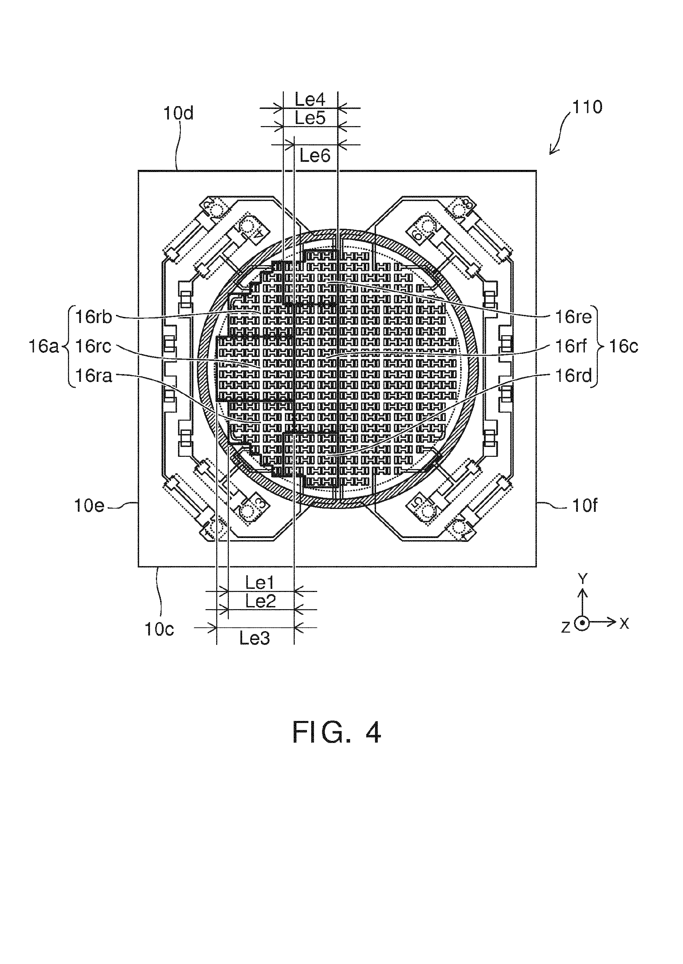

Fig. 4 is a schematic plan view exemplifying a part of the light emitting device according to the first exemplary embodiment.

As illustrated in Fig. 4, the first arrangement portion 16a includes a first region 16ra, a second region 16rb, and a third region 16rc. The first region 16ra and the second region 16rb are apart from each other in a first direction (for example, the Y axis direction) from the first side 10c to the second side 10d. The third region 16rc is provided between the first region 16ra and the second region 16rb.

For example, the third arrangement portion 16c includes a fourth region 16rd, a fifth region 16re, and a sixth region 16rf. The fourth region 16rd and the fifth region 16re are apart from each other in the first direction. The fourth region 16rd is arranged with the first region 16ra in a second direction (for example, the X axis direction) from the third side 10e to the fourth side 10f. The fifth region 16re is arranged with the second region 16rb in the second direction. The sixth region 16rf is provided between the fourth region 16rd and the fifth region 16re.

For example, the semiconductor light emitting element 20 emits light and generates heat. For example, a temperature of the semiconductor light emitting element 20 provided on the vicinity of the center of the mounting region 16 is higher than a temperature of the semiconductor light emitting element 20 provided on the vicinity of the outer circumference of the mounting region 16. In other words, a temperature of the semiconductor light emitting element 20 provided in the sixth region 16rf is higher than a temperature of the semiconductor light emitting element 20 provided in the third region 16rc. A temperature of the semiconductor light emitting element 20 provided in the sixth region 16rf is higher than a temperature of the semiconductor light emitting element 20 provided in the fifth region 16re. A temperature of the semiconductor light emitting element 20 provided in the sixth region 16rf is higher than a temperature of the semiconductor light emitting element 20 provided in the fourth region 16rd.

In the light emitting device 110 according to the exemplary embodiment, for example, a length Le1 of the first region 16ra in the second direction is smaller than a length Le3 of the third region 16rc in the second direction. For example, a length Le2 of the second region 16rb in the second direction is smaller than the length Le3. For example, a length Le4 of the fourth region 16rd in the second direction is larger than a length Le6 of the sixth region 16rf in the second direction. For example, a length Le5 of the fifth region 16re in the second direction is larger than the length Le6 of the sixth region 16rf in the second direction.

Accordingly, among the semiconductor light emitting elements 20 provided on the third arrangement portion 16c, the number of semiconductor light emitting elements 20 provided on the vicinity of the center of the mounting region 16 is reduced. In other words, among the semiconductor light emitting elements 20 to which power is supplied from a single power source via the fifth connector and sixth connector, the number of semiconductor light emitting elements 20 with a high temperature is reduced. Thus, for example, influence of heat generated when light is emitted, on characteristics of the semiconductor light emitting elements 20, is reduced. Characteristic variations of the plurality of semiconductor light emitting elements 20 are reduced, and thus color unevenness or luminance unevenness in the light emitting element portion 35 is reduced.

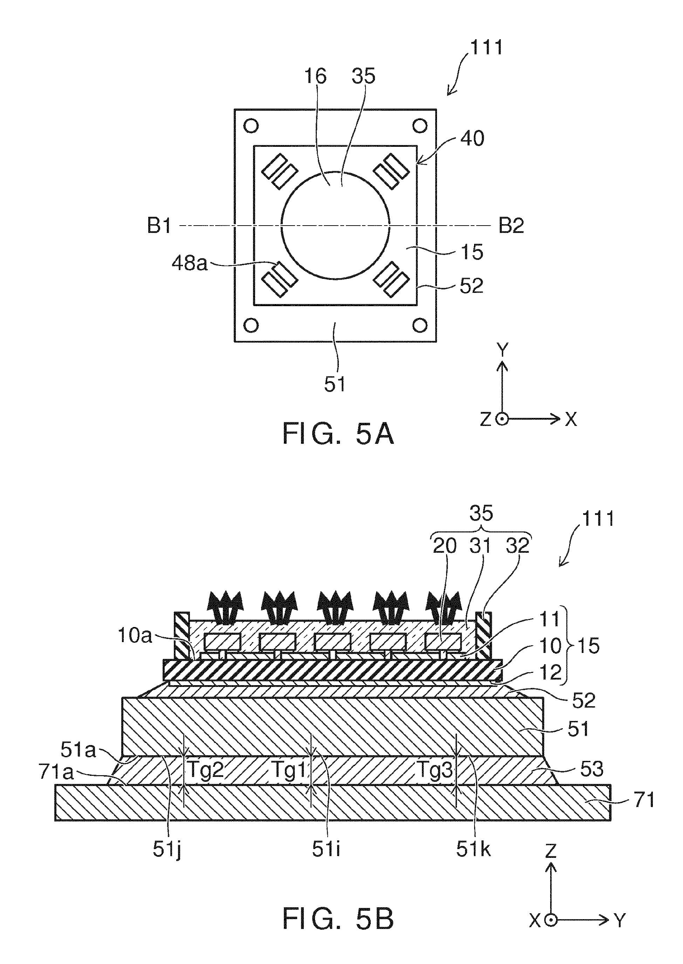

Figs. 5A and 5B are schematic diagrams exemplifying a light emitting device according to the first exemplary embodiment.

Fig. 5A is a schematic plan view. Fig. 5B is a schematic cross-sectional view exemplifying a part of a cross-section taken along the line B1-B2 of Fig. 5A.

As illustrated in Figs. 5A and 5B, also in a light emitting device 111, the base member 71, the grease layer 53, the heat dissipation plate 51, the joint layer 52, the mounting substrate portion 15, and the light emitting section 40 are provided. The configurations described related to the light emitting device 110 can be applied to the base member 71, the grease layer 53, the joint layer 52, the mounting substrate portion 15, and the light emitting section 40.

For example, alumina (aluminum oxide), aluminum nitride, aluminum oxynitride, or the like is used in the ceramic substrate 10. A thermal expansion coefficient of the ceramic substrate 10 is, for example, 4 to 10 parts per million/Kelvin (ppm/K).

For example, a metal, a composite material of a metal and a ceramic is used in the heat dissipation plate 51. As the composite material, for example, a composite material of copper (Cu) and molybdenum (Mo), a composite material of copper and tungsten (W), a composite material of aluminum (Al) and silicon carbide (SiC), or the like is used. The heat dissipation plate 51 includes at least one of the composite material of Al and SiC, the composite material of Cu and Mo, and the composite material of Cu and W.

A thermal expansion coefficient of the heat dissipation plate 51 is, for example, substantially the same as a thermal expansion coefficient of the ceramic substrate 10. For example, a ratio of the thermal expansion coefficient of the heat dissipation plate 51 and the thermal expansion coefficient of the ceramic substrate 10 is 0.5 or more and 2 or less. A thermal expansion coefficient of the composite material is, for example, 5 to 10 ppm/K. A thermal expansion coefficient of a material used in the ceramic substrate 10 is, for example, 5 to 10 ppm/K. Thermal conductivity of the heat dissipation plate is, for example, 150 watts/meter Kelvin (W/(m·K)). The thermal conductivity of the heat dissipation plate is higher than, for example, a thermal conductivity of the wiring substrate (the ceramic substrate).

In the light emitting device 111, an area of the emission region (the mounting region 16) is large. For example, a diameter of the emission region is 0.6 or times and 0.8 or less times larger than a diameter of the ceramic substrate 10 (the first main surface 10a).

For example, the base member 71 has a first base surface 71a on the light emitting section 40 side. For example, the heat dissipation plate 51 has a first heat dissipation surface 51a on the base member 71 side. The first heat dissipation surface 51a includes a central portion 51i, a first outer circumferential portion 51j, and a second outer circumferential portion 51k. The central portion 51i, the first outer circumferential portion 51j, and the second outer circumferential portion 51k are arranged on the X-Y plane. The central portion 51i is provided between the first outer circumferential portion 51j and the second outer circumferential portion 51k.

For example, an LED module, in which one or more LED chips are mounted on the ceramic substrate 10 of which circuit wires are formed on the first main surface 10a, emits light by being supplied with power, and 50% or more of the supplied power does not contribute to light emission and is converted into heat in some cases.

In the LED chip, emission efficiency (Im/W) relative to supplied power may be reduced, for example, due to heat generated by the LED when emitting light. If an amount of the supplied power is large, a temperature of the LED chip may be equal to or greater than an appropriate usage environmental temperature of the LED chip. If the LED module is mounted in a lighting apparatus, an attachment structure is designed. Accordingly, a sufficient heat dissipation path is secured.

As a structure for realizing high heat dissipation, the heat dissipation plate is provided between a COB and a casing (the base member 71). A rear surface of the COB and the heat dissipation plate are joined to each other by using solder. Silicone grease is supplied between the heat dissipation plate and the casing. In this structure, heat is dissipated via the heat dissipation plate, and an area of heat dissipation to the casing increases. Thus, a high heat dissipation characteristic can be obtained.

For example, a thermal expansion coefficient of the wiring substrate (the ceramic substrate 10) is different from a thermal expansion coefficient of the heat dissipation plate 51. A great warp may occur after solder joint. Accordingly, a thickness of the Silicone grease (the grease layer 53) supplied between the heat dissipation plate 51 and the casing may be nonuniformly distributed.

For example, a distance Tg1 between the central portion 51i and the first base surface 71a may be longer than a distance Tg2 between the first outer circumferential portion 51j and the first base surface 71a. The distance Tg1 may be longer than a distance Tg3 between the second outer circumferential portion 51k and the first base surface 71a. In other words, the thickness of the light emitting device may be large at the central portion, and may be smaller toward the outer circumferential portions.

If the emission region (the mounting region 16) is small, a distribution of the thickness of the light emitting device does not greatly influence characteristics of the light emitting device, and a temperature distribution in the emission region is small. If a high output light emitting device is used (for example, the mounting region 16 is large), a large temperature difference may occur between a temperature of the central portion of the mounting region and a temperature of the end portion of the mounting region. Characteristics of an LED vary depending on a usage temperature. Accordingly, color unevenness or luminance unevenness may occur in the emission region.

In the light emitting device 111 according to the present exemplary embodiment, a thermal expansion coefficient of the heat dissipation plate 51 is substantially the same as a thermal expansion coefficient of the wiring substrate. Accordingly, a difference hardly occurs between the distance Tg1 and the distance Tg2. A difference hardly occurs between the distance Tg1 and the distance Tg3. In other words, a warp hardly occurs in the light emitting device 111. Therefore, a nonuniform temperature distribution hardly occurs in the emission region, and unevenness of optical characteristics hardly occurs.

In the light emitting device 111, a warp is reduced while ensuring a heat dissipation characteristic, and a temperature in the emission region surface is uniformized. Thus, characteristic variations of a plurality of LEDs are reduced, and thus color unevenness or luminance unevenness in the emission region is reduced. A material with a thermal expansion coefficient similar to a thermal expansion coefficient of the wiring substrate is used in the heat dissipation plate 51. Accordingly, heat is dissipated, which leads to temperature uniformization in the emission region surface. According to the present exemplary embodiment, a high output light emitting device can be obtained. High reliability can be obtained even at a high output level.

### Second Exemplary Embodiment

For example, marking (printing or forming a state called a mark) is performed on the ceramic substrate 10 by using laser. An alumina sintered body used in the ceramic substrate is irradiated with the laser. Thus, for example, some oxygen of the alumina sintered body is removed in a region (marking region) irradiated with the laser. An oxygen vacancy is formed. The oxygen vacancy optically selectively absorbs, for example, blue of white light. Accordingly, for example, the alumina sintered body emits yellow light. Therefore, marking using the laser can be performed.

In the present exemplary embodiment, prior to marking using irradiation (main irradiation) with laser, irradiation (preliminary irradiation) with laser having power lower than power of laser used for the main irradiation is performed. Therefore, contrast of marking after the main irradiation can be increased.

A surface of the alumina sintered body is preliminarily irradiated with laser. Accordingly, an oxygen vacancy is formed. The oxygen vacancy, for example, triggers off absorption of laser (laser marking light) of the main irradiation. The preliminary irradiation is, for example, laser light irradiation for generating the oxygen vacancy. The present exemplary embodiment proposes a two-step laser light irradiation process in which the main irradiation is performed following the preliminary irradiation.

Power of laser used for the preliminary irradiation is appropriately selected. Accordingly, for example, an oxygen vacancy remains in a marking area even after laser marking due to the main irradiation. Therefore, the alumina sintered body is further promoted to emit yellow light. Contrast of marking after the main irradiation can be increased.

An oxygen vacancy in α-Al₂O₃ includes, for example, an F+ center, an F center, or the like. The F+ center is an oxygen vacancy in which a single electron is occupied. A peak of a PL spectrum occurs at 325 mm due to the F+ center. The F center is an oxygen vacancy in which two electrons are occupied. A peak of a PL spectrum occurs at 410 mm due to the F center. For example, an oxygen vacancy of an alumina surface can be evaluated by using a PL spectrum which uses ultraviolet laser light as an excitation source.

For example, a surface of sintered alumina is irradiated with laser with power lower than power of laser used for the main irradiation. Accordingly, for example, an oxygen vacancy is introduced into a sintered alumina material. A PL spectrum of the sintered alumina into which the oxygen vacancy is introduced is observed by using ultraviolet laser light as an excitation source. For example, a peak intensity of the PL spectrum in a near-ultraviolet region (a wavelength is 330 nm or more and 440 nm) is observed. This peak occurs, for example, due to the oxygen vacancy. Power of laser used for the preliminary irradiation is appropriately selected on the basis of the peak intensity. For example, power of laser which further increases an intensity of a PL peak before irradiation with laser light than an intensity of a PL peak after the irradiation with laser light is set as power of laser used for the preliminary irradiation. The preliminary irradiation is performed in a selected condition, and then the main irradiation is performed.

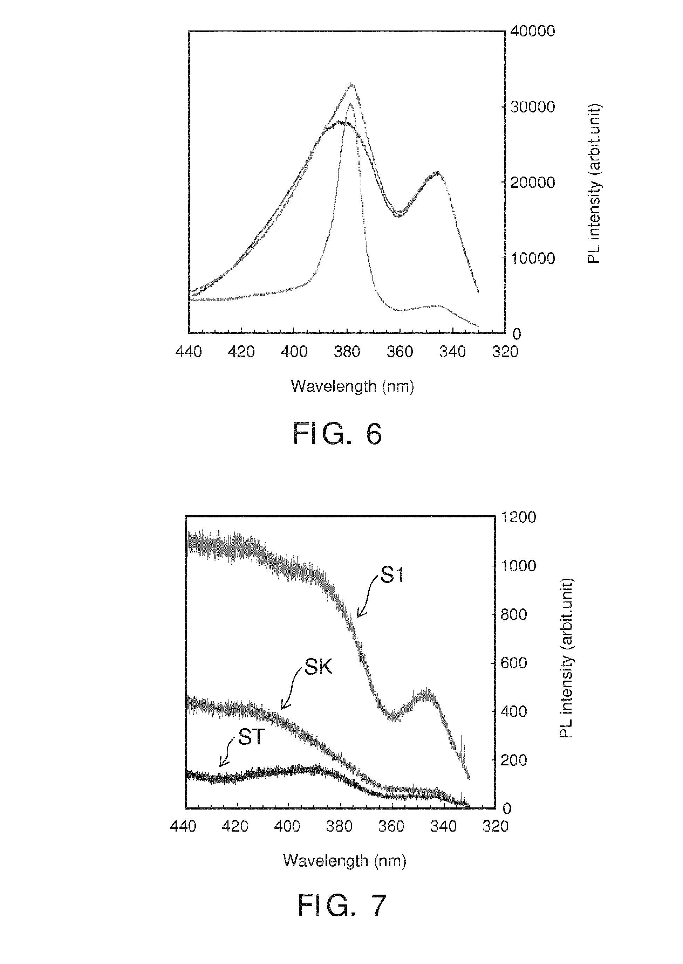

Fig. 6 is a graph exemplifying characteristics of sintered alumina.

Fig. 6 exemplifies PL spectra in three different items of sintered alumina. The sintered alumina is a laser marking good product in which contrast after laser marking is large. As illustrated in Fig. 6, a broad peak or a relatively sharp peak is confirmed in a region in which a wavelength is 380 nm or more and 390 nm or less.

Fig. 7 is a graph exemplifying characteristics of alumina.

Fig. 7 exemplifies a PL spectrum of sintered alumina S1, a PL spectrum of high purity alumina SK, and a PL spectrum of high purity alumina ST. The sintered alumina S1 is a laser marking defective product in which contrast after laser marking is small. The PL spectrum of the high purity alumina SK and the PL spectrum of the high purity alumina ST are for reference.

As illustrated in Fig. 6, the peak with a high intensity around (near) 380 nm is confirmed in the PL spectrum of the alumina sintered body which is a laser marking good product. On the other hand, as illustrated in Fig. 7, the peak intensity around 380 nm is low in the PL spectrum of the sintered alumina S1 which is a laser marking defective product. Substantially, the intensity is an intensity which is not regarded as a peak. The PL spectrum of the high purity alumina SK and the PL spectrum of the high purity alumina ST are the same as the PL spectrum of the alumina sintered body S1. In other words, a peak is not shown around 380 nm. An impurity concentration of a high purity alumina material is low, and has few oxygen vacancies. The high purity alumina material is not suitable for laser marking.

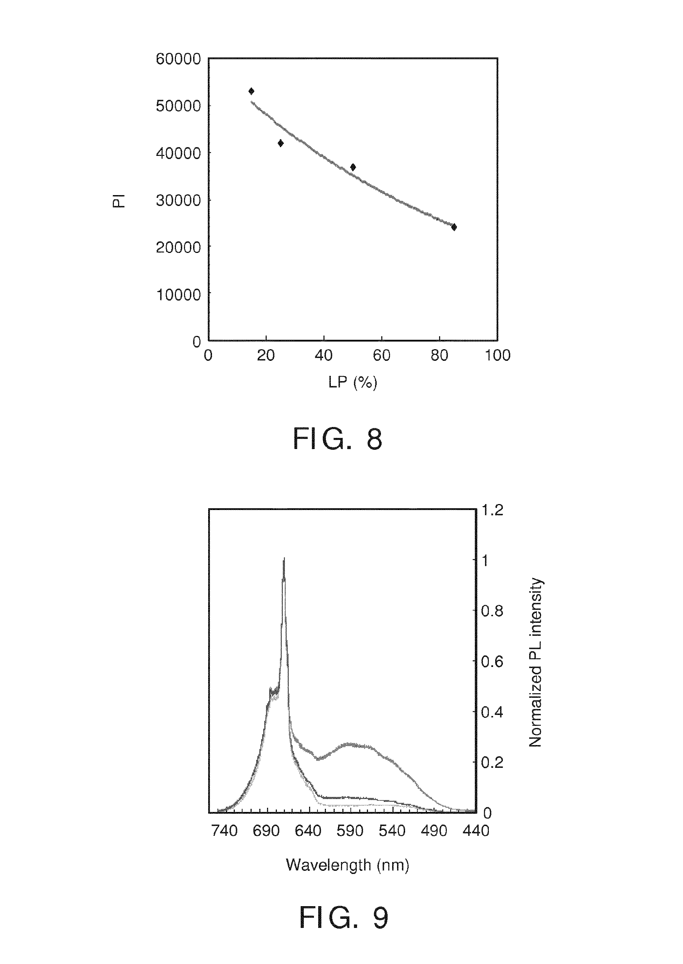

Fig. 8 is a graph exemplifying characteristics of sintered alumina.

A transverse axis of Fig. 8 expresses laser power LP. A longitudinal axis of Fig. 8 expresses a peak intensity PI around 380 nm of a PL spectrum. For example, a peak intensity PI of a PL spectrum in sintered alumina which is not irradiated with laser is about 2800. For example, laser power LP of laser used for the main irradiation is 85%.

For example, laser whose laser power LP is 15% is used for the preliminary irradiation. In this case, as illustrated in Fig. 8, the peak intensity PI after laser irradiation is about 5400. Due to the preliminary irradiation, the peak intensity PI substantially doubles the peak intensity PI before the laser irradiation. This is based on the fact that there is an introduction of oxygen vacancies with higher concentration than a concentration of oxygen vacancies of the sintered alumina surface on which the laser irradiation is not performed.

For example, a result is obtained in which marking contrast when the main irradiation is performed after the preliminary irradiation using laser with 25% of power improves three times higher than the marking contrast when only the main irradiation is performed. In addition, a result is obtained in which marking contrast when the main irradiation is performed after the preliminary irradiation using laser with 15% of power improves five times higher than the marking contrast when only the main irradiation is performed.

The alumina has high insulation. For this reason, the alumina is used as a substrate material of many electronic devices. Industrially, alumina particulates are mixed with a sintering assistant so as to be sintered. Thus, an alumina sintered body is obtained. For example, SiO₂ which is an inorganic oxide and particulates of an alkaline earth metal oxide are used as the sintering assistant. For example, CaO or MgO is used as the alkaline earth metal oxide.

A high output carbon dioxide gas laser, Nd;YAG laser, or the like is used for laser marking. An oscillation wavelength of the carbon dioxide gas laser is 10.6 µm. An oscillation wavelength of the Nd;YAG laser is 1.06 µm. Meanwhile, a band gap of the alumina is 8 eV to 9 eV. The alumina is a substantially complete insulator. For this reason, the alumina substantially does not absorb the carbon dioxide gas laser or the Nd;YAG laser at all.

In relation to laser absorption of the alumina sintered body, impurities contained in the alumina sintered body or in the sintering assistant may trigger off laser absorption. The impurities are, for example, an ion (Cr³⁺) of Cr, and the like. In the alumina sintered body, some ions (Al³⁺) of Al are replaced with Cr³⁺.

For example, in the laser marking, there is a method of a reference example in which these impurities are used as a trigger for absorbing laser light. In the method, if desired marking contrast is not obtained, coating for absorbing laser light may be applied to an alumina sintered substrate surface. A material such as PbCrO₄ which is an inorganic oxide including Cr is used for the coating. However, using Cr is great burdens on the environments. Preferably, the use of Cr is avoided.

Due to this environmental problem, laser light absorption materials equal to or lower than Cr may be used. In the laser marking, plasma called a laser plume is inevitably generated. There may be the occurrence of a defect in which an inorganic material which absorbs laser light is scattered around a marked part due to the plasma. For example, a cleaning process for cleaning the scattered inorganic material may be added. From the viewpoint of simplification of processes, the addition of the cleaning process is not preferable. If a mounted member is located on an alumina sintered body surface, cleaning may not be easily performed. Production may be hindered.

On the other hand, in the present exemplary embodiment, an oxygen vacancy of the alumina is used as a trigger for absorbing laser light. Cr is not used, and thus burdens on environments are eliminated. An inorganic material is not scattered around a marked part, and processes are simplified.

For example, as another reference example for improving marking contrast, there is a method in which ions are made to collide with each other in a state in which a negative bias is applied to sintered alumina. For example, ions (Ar⁺) of argon are made to collide with each other in an argon atmosphere. For example, ions (O⁺) of oxygen are made to collide with each other in an oxygen atmosphere. In this method, there is the occurrence of a defect in which an oxygen vacancy is also introduced into locations other than a laser marking region. The introduction of an unnecessary oxygen vacancy into a sintered alumina material influences electrical insulation withstand voltage characteristics and thus is not preferable.

On the other hand, in the present exemplary embodiment, an oxygen vacancy is introduced due to the preliminary irradiation. In the laser marking, marking is performed on a surface of a sintered alumina material by using a galvano-mirror. The galvano-mirror is controlled by a computer. Accordingly, in the main irradiation, substantially exactly the same location as a location irradiated in the preliminary irradiation can be irradiated. An oxygen vacancy is not introduced into locations other than a laser marking region.

In laser marking on a sintered alumina material which is industrially used, an oxygen vacancy is introduced into a sintered alumina surface in advance by using laser light. Therefore, marking contrast increases. Even in a material in which contrast is insufficient when laser marking is performed, practical contrast can be obtained.

If marking contrast due to laser marking is small, there is a case where laser with the same power may be applied multiple times. This case is not preferable since an oxygen vacancy concentration becomes lower than a concentration in a surface, and thus a location with low absorptance of laser light is irradiated with the laser. As in the present exemplary embodiment, the main irradiation is preferably performed after the optimized preliminary irradiation is performed.

The sintered alumina includes a sintering assistant with a high concentration. However, an oxygen vacancy concentration can be selectively evaluated only for an alumina component without depending on the presence of the sintering assistant, through evaluation of a PL spectrum according to the present exemplary embodiment.

### Third Exemplary Embodiment

Marking is performed on sintered alumina by using a carbon dioxide gas laser. In the present exemplary embodiment, Cr³⁺ of the sintered alumina is used as a trigger for absorbing laser light.

A PL spectrum of the sintered alumina is observed by using ultraviolet rays with a wavelength of 325 nm. For example, a peak intensity in the PL spectrum is evaluated at a wavelength of 650 nm or more and 680 nm or less. Accordingly, a concentration of Cr³⁺ in the sintered alumina can be evaluated. A concentration of Cr³⁺ which allows favorable marking contrast to be obtained can be evaluated.

In alumina (Al₂O₃), a trivalent cation (Al³⁺) of Al may be replaced with a trivalent cation (Cr³⁺) of Cr. For example, a ruby has a structure in which some Al³⁺ are replaced with Cr³⁺. In the ruby, a concentration of Cr³⁺ is about 500 ppm. The ruby was used in a ruby laser as an initial laser medium.

The PL spectrum of the sintered alumina shows two peaks due to Cr³⁺ at a wavelength of 670 nm or more and 700 nm or less. These peaks are peaks with a very narrow spectral width. A concentration of Cr³⁺ in the alumina material can be evaluated by using the peaks.

For an industrial sintered alumina material, zirconia toughened alumina (ZTA) which is toughened with zirconia is known. If the material is excited by using light of a wavelength of 319 nm, a PL spectrum of the material shows a peak at 676 nm (1.83 eV) and a peak at 692 nm (1.79 eV). If the material is excited by using light of a wavelength of 558 nm (2.22 eV), a PL spectrum of the material shows a peak at 692 nm, but does not show a peak at 676 nm. For example, a peak wavelength in a PL spectrum varies depending on an excitation wavelength. If the material is excited by using light of a wavelength of 400 nm (3.10 eV), an intensity of the peak at 676 nm is smaller than an intensity of the peak at 692 nm. Depending on an excitation wavelength, a peak wavelength of a PL spectrum varies, and a ratio of two peak intensities also varies. The two PL spectrum peaks correspond to light emission caused by Cr³⁺.

An excitation wavelength is defined, and thus a PL spectrum in the alumina sintered body is measured. Thus, a concentration of Cr³⁺ can be evaluated.

For example, an intensity ratio of the two peaks corresponding to light emission caused by Cr³⁺ is evaluated. Accordingly, favorable marking contrast can be obtained when marking is performed on the sintered alumina material by using a carbon dioxide gas.

Fig. 9 is a graph exemplifying characteristics of sintered alumina.

Fig. 9 exemplifies PL spectra in three different laser marking good products. The respective PL spectra are normalized to a maximal peak intensity at 670 nm. As illustrated in Fig. 9, a peak intensity at 690 nm is about a half of a peak intensity at 670 nm.

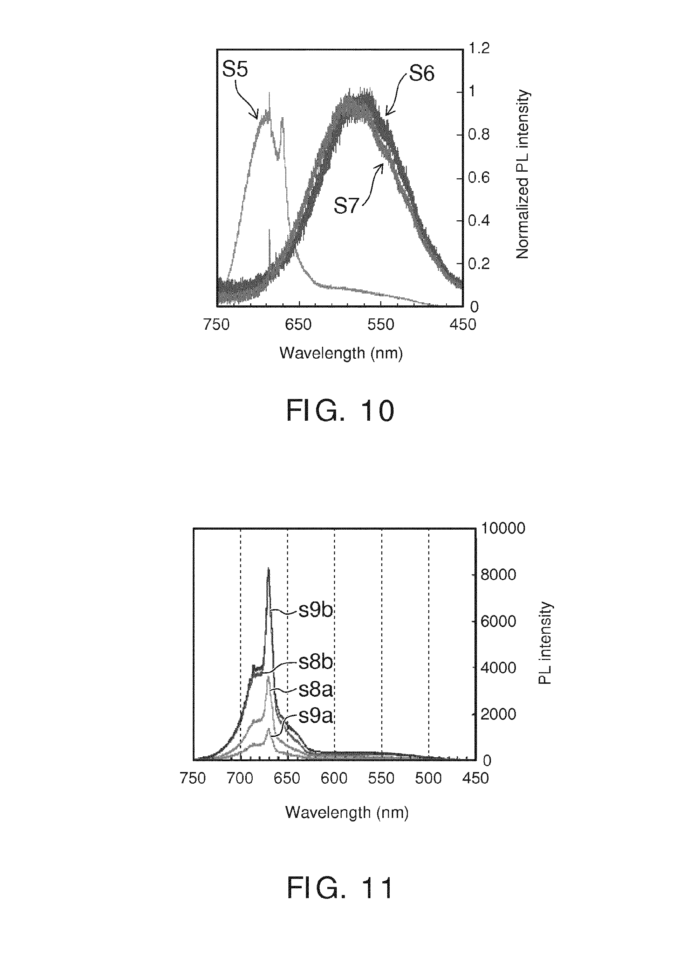

Fig. 10 is a graph exemplifying characteristics of alumina.

Fig. 10 exemplifies a PL spectrum of sintered alumina S5, a PL spectrum of high purity alumina S6, and a PL spectrum of high purity alumina S7. The respective PL spectra are normalized to a maximal peak intensity. The sintered alumina S5 is a laser marking defective product. As illustrated in Fig. 10, in the laser marking defective product, a peak intensity at 670 nm is equivalent to a peak intensity at 690 nm. This indicates that, for example, a concentration of Cr³⁺ used as a trigger for absorbing carbon dioxide gas laser light is low.

A peak intensity at 670 nm and a peak intensity at 690 nm are evaluated. Accordingly, for example, whether or not marking contrast can be increased can be understood before laser marking.

For example, if a peak intensity at 670 nm is equal to or lower than a peak intensity at 690 nm, an absorbent used as a trigger for absorbing laser light is coated on a surface. Therefore, the laser light can be absorbed with high efficiency.

Fig. 11 is a graph exemplifying characteristics of sintered alumina.

Fig. 11 exemplifies a PL spectrum S8b of sintered alumina S8 before laser marking, a PL spectrum S8a of the sintered alumina S8 after laser marking, a PL spectrum S9b of sintered alumina S9 before laser marking, and a PL spectrum S9a of the sintered alumina S9 after laser marking.

The sintered alumina S8 and the sintered alumina S9 show, for example, the PL spectra shown by the sintered alumina which is a laser marking good product as illustrated in Fig. 9. Meanwhile, marking contrast in the sintered alumina S9 is lower than marking contrast in the sintered alumina S8.

As illustrated in Fig. 11, a peak intensity of the PL spectrum S9a at 670 nm is lower than a peak intensity of the PL spectrum S8a at 670 nm. In relation to the sintered alumina S9, a peak intensity of the PL spectrum S9a is considerably lower than a peak intensity of the PL spectrum S9b.

A peak intensity at 670 nm after laser marking is preferably 0.4 or more times higher than a peak intensity at 670 nm before the laser marking.

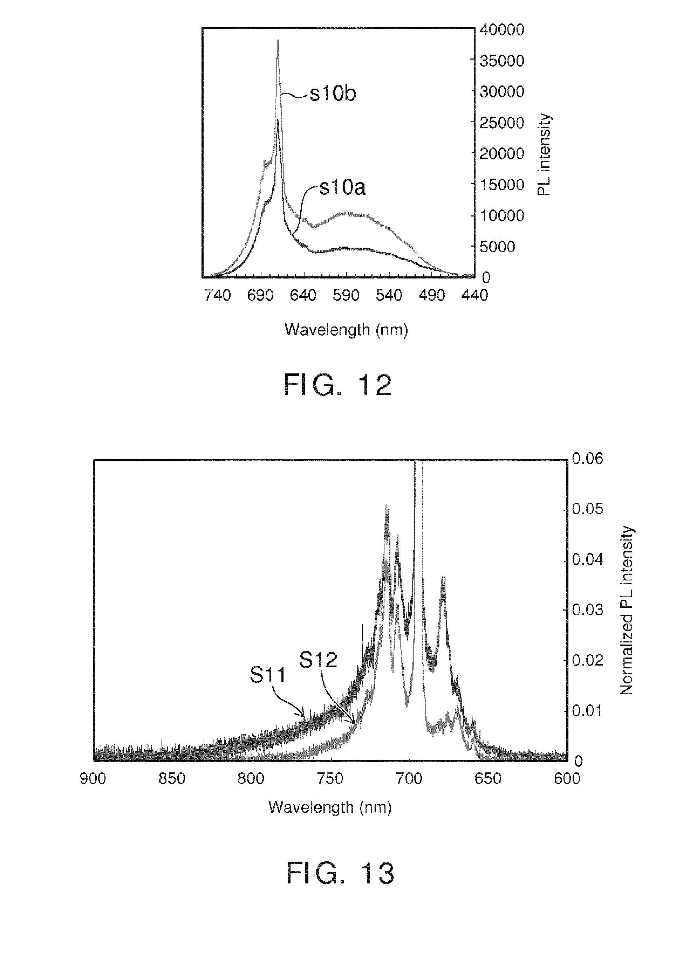

Fig. 12 is a graph exemplifying characteristics of sintered alumina.

Fig. 12 exemplifies a PL spectrum S10b of sintered alumina S10 before laser marking, and a PL spectrum S10a of the sintered alumina S10 after laser marking. In the sintered alumina S10, laser marking contrast is favorable.

The PL spectrum S10b shows a peak whose intensity is the maximum at 670 nm and shows a shoulder peak at 690 nm in the same manner as the PL spectrum illustrated in Figs. 9 and 11. In addition, the PL spectrum S10b shows a broad peak around 570 nm. As illustrated in Fig. 12, also in the PL spectrum of the sintered alumina S10, a peak intensity at 670 nm after laser marking is 0.4 or more times higher than a peak intensity at 670 nm before the laser marking. This supports that a peak intensity at 670 nm after the laser marking is preferably 0.4 or more times higher than a peak intensity at 670 nm before the laser marking. The broad peak at 570 nm shown in the PL spectrum S10b may also result from light emission caused by Cr³⁺.

Fig. 13 is a graph exemplifying characteristics of sintered alumina.

Fig. 13 exemplifies a PL spectrum of sintered alumina S11 and a PL spectrum of sintered alumina S12. The spectra are PL spectra obtained when excitation is performed by using light of a wavelength of 514.5 nm. The respective PL spectrum are normalized to a maximal peak intensity at 694 nm.

The sintered alumina S11 is a laser marking good product. The sintered alumina S12 is a laser marking defective product. A peak at 694 nm where an intensity of the spectrum is the maximum results from light emission caused by Cr³⁺. The PL spectrum of the sintered alumina S11 shows a sharp peak around 680 nm. On the other hand, in the PL spectrum of the sintered alumina S12, a clear sharp peak around 680 nm is not recognized. The peak around 680 nm results from light emission caused by, for example, Mn⁴⁺.

For example, a PL spectrum is observed when excitation is performed by using visible light of a wavelength of 514.5 nm instead of ultraviolet rays of a wavelength of 325 nm. Thus, whether or not an alumina sintered body is suitable for laser marking can be determined by using not only a concentration of Cr³⁺ but also a concentration of Mn⁴⁺.

When laser marking is performed on a sintered alumina material which is used industrially, a PL spectrum of sintered alumina is observed by performing excitation with ultraviolet rays of a wavelength of 325 nm. For example, a ratio of an intensity of a peak at 670 nm and an intensity of a peak at 690 nm is evaluated. These peaks are based on light emission caused by, for example, Cr³⁺. Thus, a concentration of Cr³⁺ in the sintered alumina can be evaluated.

For example, a PL spectrum of sintered alumina is observed by performing excitation with visible light of a wavelength of 514.5 nm. For example, whether or not there is a peak around 680 nm is evaluated. Accordingly, a concentration of Mn⁴⁺ in the sintered alumina can be evaluated. Contrast of laser marking can be improved.

In addition, a sintered alumina material may be formed so as to satisfy both conditions suitable for laser marking described in the second exemplary embodiment and the third exemplary embodiment.

According to the exemplary embodiment, a high reliability light emitting device is provided.

In addition, in the present specification, the terms "perpendicular" and "parallel" do not only indicate strict perpendicular and parallel but also include, for example, variations in manufacturing steps or the like, and may be substantially perpendicular and substantially parallel.

The exemplary embodiments were described with reference to the specific examples. However, the invention is not limited to the specific examples. For example, specific configurations of the respective constituent elements such as the semiconductor light emitting element, the mounting substrate portion, the heat dissipation plate, the ceramic substrate, the first metal layer, the second metal layer, and the joint layer are included in the scope of the invention as long as a person skilled in the art appropriately selects the configurations from a well-known range so as to implement the invention and achieve the same effect.

Further, combinations two or more constituent elements of the respective specific examples in the scope which is technically possible are included in the scope of the invention as long as the combinations cover the spirit of the invention.

Furthermore, all light emitting devices, which can be implemented by a person skilled in the art through appropriate design modifications on the basis of the above light emitting device described as the exemplary embodiments of the invention, are also included in the scope of the invention as long as the light emitting devices cover the spirit of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting device (110) comprising:
a ceramic substrate (10) provided with a first main surface (10a) including a first side (10c); a second side (10d) apart from the first side (10c); a third side (10e); a fourth side (10f) apart from the third side (10e); a first corner portion (10g) connecting the first side (10c) to the third side (10e); a second corner portion (10h) connecting the third side (10e) to the second side (10d); a third corner portion (10i) connecting the second side (10d) to the fourth side (10f); and a fourth corner portion (10j) connecting the fourth side (10f) to the first side (10c), the first main surface including a mounting region (16); a first connector region (10k) provided between the mounting region (16) and the first corner portion (10g); a second connector region (10l) provided between the second corner portion (10h) and the mounting region (16); a third connector region (10m) provided between the third corner portion (10i) and the mounting region (16); and a fourth connector region (10n) provided between the fourth corner portion (10j) and the mounting region (16);
a plurality of semiconductor light emitting elements (20) provided on the mounting region (16);
a first connector (48a) provided on the first connector region (10k);
a second connector (48b) provided on the second connector region (10l);
a third connector (48c) provided on the third connector region (10m);
a fourth connector (48d) provided on the fourth connector region (10n); and
a first metal layer (11) provided between the plurality of semiconductor light emitting elements (20) and the ceramic substrate (10), the first metal layer (11) including a first connector electrode portion (47a) electrically connected to the first connector (48a); a second connector electrode portion (47b) electrically connected to the second connector (48b); a third connector electrode portion (47c) electrically connected to the third connector (48c); and a fourth connector electrode portion (47d) electrically connected to the fourth connector (48d).

2. The device (110) according to claim 1, wherein
the first connector (48a) includes:
a first connector side (48aa);
a second connector side (48ab) provided between the first connector side (48aa) and the mounting region (16), the second connector side (48ab) being apart from the first connector side (48aa);
a third connector side (48ac) connected to one end of the first connector side (48aa) and one end of the second connector side (48ab); and
a fourth connector side (48ad) connected to the other end of the first connector side (48aa) and the other end of the second connector side (48ab), and
an angle between an extending direction of the first connector side (48aa) and a direction from the mounting region (16) to the first corner portion (10g) is 80 degrees or more and 100 degrees or less.

3. The device (110) according to claim 1 or 2, further comprising:
a fifth connector (48e);
a sixth connector (48f);
a seventh connector (48g); and
an eight connector (48h),
the first main surface (10a) further including
a fifth connector region (10o) provided between the first corner portion (10g) and the first connector region (10k);
a sixth connector region (10p) provided between the second corner portion (10h) and the second connector region (10l);
a seventh connector region (10q) provided between the third corner portion (10i) and the third connector region (10m); and
an eighth connector region (10r) provided between the fourth corner portion (10j) and the fourth connector region (10n),
the fifth connector (48e) being provided on the fifth connector region (10o),
the sixth connector (48f) being provided on the sixth connector region (10p),
the seventh connector (48g) being provided on the seventh connector region (10q),
the eighth connector (48h) being provided on the eighth connector region (10r),
the first metal layer (11) further including
a fifth connector electrode portion (47e) electrically connected to the fifth connector (48e);
a sixth connector electrode portion (47f) electrically connected to the sixth connector (48f);
a seventh connector electrode portion (47g) electrically connected to the seventh connector (48g); and
an eighth connector electrode portion (47h) electrically connected to the eighth connector (48h).

4. The device (110) according to claim 3, wherein
the mounting region (16) includes
a first arrangement portion (16a);
a second arrangement portion (16b) provided between the fourth side (10f) and the first arrangement portion (16a);
a third arrangement portion (16c) provided between the first arrangement portion (16a) and the second arrangement portion (16b); and
a fourth arrangement portion (16d) provided between the second arrangement portion (16b) and the third arrangement portion (16c),
the first metal layer (11) further includes
a first mounting pattern portion (11fa) provided on the first arrangement portion (16a);
a second mounting pattern portion (11fb) provided on the second arrangement portion (16b);
a third mounting pattern portion (11fc) provided on the third arrangement portion (16c); and
a fourth mounting pattern portion (11fd) provided on the fourth arrangement portion (16d),
the first connector electrode portion (47a) and the second connector electrode portion (47b) are electrically connected to the first mounting pattern portion (11fa),
the third connector electrode portion (47c) and the fourth connector electrode portion (47d) are electrically connected to the second mounting pattern portion (11fb),
the fifth connector electrode portion (47e) and the sixth connector electrode portion (47f) are electrically connected to the third mounting pattern portion (11fc), and
the seventh connector electrode portion (47g) and the eighth connector electrode portion (47h) are electrically connected to the fourth mounting pattern portion (11fd).

5. The device (110) according to claim 4, wherein
the first arrangement portion (16a) includes
a first region (16ra);
a second region (16rb) apart from the first region (16ra) in a first direction from the first side (10c) to the second side (10d); and
a third region (16rc) provided between the first region (16ra) and the second region (16rb),
the third arrangement portion (16c) includes
a fourth region (16rd) arranged with the first region (16ra) in a second direction from the third side (10e) to the fourth side (10f);
a fifth region (16re) arranged with the second region (16rb) in the second direction, the fifth region(16re) being apart from the fourth region (16rd) in the first direction; and
a sixth region (16rf) provided between the fourth region (16rd) and the fifth region (16re),
a length of the third region (16rc) in the second direction is larger than a length of the first region (16ra) in the second direction,
the length of the third region (16rc) in the second direction is larger than a length of the second region (16rb) in the second direction,
a length of the sixth region (16rf) in the second direction is smaller than a length of the fourth region (16rd) in the second direction, and
the length of the sixth region (16rf) in the second direction is smaller than a length of the fifth region (16re) in the second direction.

6. The device (110) according to claim 1, wherein a distance between the first connector region (10k) and the mounting region (16) is 2.5 millimeters or more.

7. The device (111) according to any one of claims 1 to 6, further comprising:
a second metal layer (12);
a solder layer (52); and
a heat dissipation plate (51),
the ceramic substrate (10) being provided between the first metal layer (11) and the second metal layer (12),
the solder layer (52) being provided between the heat dissipation plate (51) and the second metal layer (12),
a ratio of a thermal expansion coefficient of the heat dissipation plate (51) to a thermal expansion coefficient of the ceramic substrate (10) being 0.5 or more and 2 or less.

8. The device (111) according to claim 7, wherein
the ceramic substrate (10) includes at least one of aluminum oxide, aluminum nitride, and aluminum oxynitride, and
the heat dissipation plate (51) includes at least one of a composite material including aluminum and silicon carbide, a composite material including copper and molybdenum, and a composite material including copper and tungsten.
